# EUROPÄISCHE PATENTSCHRIFT

(11) **EP 2 389 059 B1**
(45) Veröffentlichungstag und Bekanntmachung des Hinweises auf die Patenterteilung: **22.06.2016**
(21) Anmeldenummer: 11166546.9
(22) Anmeldetag: 18.05.2011
(51) Int. Cl.: H05K 13/04

(54) **Bestückkopf für einen Bestückautomaten, Bestückautomat sowie Bestückverfahren**
Mounting head for a mounting machine, mounting machine and mounting method
Tête à implanter pour un automate d'alimentation, automate d'alimentation et procédé d'alimentation

(30) Priorität: 19.05.2010 DE 102010021069
(43) Veröffentlichungstag der Anmeldung: 23.11.2011
(73) Patentinhaber: ASM Assembly Systems GmbH & Co. KG, 81379 München (DE)
(72) Erfinder: Müller, Werner, 83607 Holzkirchen (DE)
(74) Vertreter: Kuhlmann, Kai

(56) Entgegenhaltungen:
- EP-A2- 1 734 802
- EP-A2- 1 903 850
- WO-A1-2009/060589
- CN-A- 101 102 661

## Beschreibung

Die Erfindung betrifft einen Bestückkopf für einen Bestückautomaten zum Bestücken von Substraten mit Bauelementen. Ferner betrifft die Erfindung einen Bestückautomaten zum Bestücken von Substraten mit Bauelementen sowie ein Bestückverfahren zum Bestücken von Substraten mit Bauelementen.

In der Bestücktechnik werden Substrate, beispielsweise Leiterplatten, mit Hilfe sogenannter Bestückautomaten mit Bauelementen verschiedenster Art bestückt. Beispielsweise können die Bauelemente mechanischer oder elektronischer Art sein. Die Bauelemente werden durch seitlich am Bestückautomaten angeordnete Zuführeinrichtungen an definierten Abholpositionen bereit gestellt. Ein durch ein Positioniersystem verfahrbarer Bestückkopf des Bestückautomaten holt die Bauelemente an den Abholpositionen ab und transferiert sie zu einem Bestückbereich des Bestückautomaten, wo sie auf bereitgestellten Substraten positioniert werden. Die zu bestückenden Substrate werden über eine Transporteinrichtung dem Bestückbereich zugeführt. Fertig bestückte Substrate werden über diese Transporteinrichtung wieder aus dem Bestückbereich heraus transportiert. Zwischen dem Abholen der Bauelemente und dem Positionieren auf dem Substrat können die Bauelemente mit Hilfe einer geeigneten Erfassungseinrichtung, beispielsweise einer Bauelemente-Kamera, hinsichtlich ihrer Lage relativ zum Bestückkopf sowie hinsichtlich etwaiger Fehler überprüft werden.

Heutzutage gibt es zu den verschiedenen Applikationen oder Anforderungen verschiedene Bestückköpfe, die jeweils einen bestimmten Anwendungsbereich abdecken können. Beispielsweise werden Applikationen im Speed-Bereich oder im Flex-Bereich durch jeweils unterschiedliche Bestückköpfe bedient. Sollte sich eine Applikation oder eine Anforderung bei einem Kunden ändern, können die Bestückköpfe des Bestückautomaten getauscht werden. Das Gleiche gilt bei einem Defekt am Bestückkopf. Auch hier wird entweder der gesamte Bestückkopf getauscht oder der Bestückkopf wird im Bestückautomaten repariert. Da die Bestückköpfe in der Regel technisch komplex und ergonomisch schwer zugänglich sind, ist eine Reparatur von Teilen des Bestückkopfes nur sehr erschwert möglich und erfordert einen Stillstand der Maschine und häufig der gesamten Linie was zu einem wirtschaftlichen Schaden bei dem Betreiber führt. Der Bestückkopf kann zwar sehr einfach an dem Bestückautomaten befestigt sein, so dass ein Austausch einfach vonstattengeht, aber der komplette Austausch eines Bestückkopfes ist sehr kostenaufwändig, da als Ersatz ein neuer Bestückkopf vorhanden sein muss.

Aus der WO 2009/060589 A1 ist eine Bauelement-Montagevorrichtung zum Montieren von elektronischen Bauelementen auf einer Leiterplatte mittels einer Adsorptionsdüse, die entfernbar in einem Montagekopf platziert ist, bekannt. Der Montagekopf ist von einem Mehrfachtyp und enthält eine Vielzahl von Einheitsmontageköpfen. Jeder der Einheitsmontageköpfe umfasst eine Adsorptionsdüse zum Adsorbieren und Halten eines elektronischen Bauelements an einem unteren Endteil, wobei die Einheitsmontageköpfe individuell nach oben und unten bewegt werden können. An den Einheitsmontageköpfen sind jeweils Vakuumsaugeinrichtungen zum Erzeugen eines Unterdrucks vorgesehen.

Aus der EP 1 734 802 A2 ist ein Bestückkopf für einen Bestückautomaten zum Bestücken von Substraten mit elektrischen Bauteilen bekannt. Der sogenannte Matrix-Bestückkopf weist mehrere Greifereinheiten auf, welche in zwei Reihen angeordnet sind und einen identischen Aufbau haben. Die Greifereinheiten können beispielsweise Sauggreifer aufweisen, deren Spitze durch Vakuum-Erzeugermodule, welche wahlweise mit Vakuum oder mit Druckluft beaufschlagt werden können.

Ein ähnlicher Bestückkopf für einen Bestückautomaten ist aus der EP 1 903 850 A2 bekannt.

Aus der CN 101 102 661 A1 ist ein modularisierter Bestückkopf bekannt, bei dem gleichartige Bestückkopfmodule an einem einzigen Rahmen fixiert werden.

Aufgabe der Erfindung ist es, einen Bestückkopf für einen Bestückautomaten zum Bestücken von Substraten mit Bauelementen zu schaffen, der modular und einfach ausgebildet ist, der kostengünstig ist und an dem auf einfache Art und Weise verschiedenartige Bestückkopfmodule montiert und demontiert werden können. Ferner soll durch einen einfachen und modular ausgebildeten Bestückkopf ein einfacher und flexibler Bestückautomat geschaffen und ein einfaches und flexibles Bestücken von Substraten mit Bauelementen ermöglicht werden.

Die Aufgabe wird durch einen Bestückkopf mit den Merkmalen gemäß dem unabhängigen Patentanspruch 1, durch einen Bestückautomaten mit den Merkmalen gemäß Patentanspruch 12 sowie durch ein Bestückverfahren mit den Merkmalen gemäß Patentanspruch 13 gelöst. Weitere Merkmale und Details der Erfindung ergeben sich aus den Unteransprüchen, der Beschreibung und den Zeichnungen. Dabei gelten Merkmale und Details, die im Zusammenhang mit dem erfinderischen Bestückkopf beschrieben sind, selbstverständlich auch im Zusammenhang mit dem erfindungsgemäßen Bestückautomaten und dem erfindungsgemäßen Bestückverfahren und jeweils umgekehrt, so dass bezüglich der Offenbarung zu den einzelnen Erfindungsaspekten stets wechselseitig Bezug genommen wird. Gemäß dem ersten Aspekt der Erfindung wird die Aufgabe durch einen Bestückkopf für einen Bestückautomaten zum Bestücken von Substraten mit Bauelementen gelöst, wobei der Bestückkopf ein Rahmenelement zur Befestigung von Bestückkopfmodulen aufweist, wobei das Rahmenelement zwei oder mehrere Schnittstellen aufweist, die jeweils zur Übertragung von Energie, Daten und/oder Luft zu jeweils einem Bestückkopfmodul ausgebildet sind, und wobei zumindest zwei Schnittstellen des Rahmenelementes identisch ausgebildet sind. Dadurch, dass die Schnittstellen identisch ausgebildet sind, ist der Bestückkopf kunden- und anforderungsspezifisch sehr einfach konfigurierbar. Eine derartige Ausgestaltung des Bestückkopfes ermöglicht eine Konfigurierung des Bestückkopfes mit äußerlich identisch ausgebildeten Bestückkopfmodulen. Die an dem Rahmenelement des Bestückkopfes befestigten Bestückkopfmodule können genormt ausgebildet werden, da zumindest zwei, bevorzugterweise alle Schnittstellen des Rahmenelementes, identisch ausgebildet sind. Ist beispielsweise ein Bestückkopfmodul defekt, kann dieses sehr einfach durch ein gleiches Bestückkopfmodul ausgetauscht werden. Die Schnittstellen an den Bestückkopfmodulen sind vorzugsweise ebenfalls alle identisch ausgebildet, um komplementär zu den Schnittstellen des Rahmenelementes ausgebildet zu sein. Ein derartig ausgebildeter Bestückkopf kann je nach Applikation und Anforderungen des Kunden einfach umkonfiguriert werden. Das heißt, einzelne Bestückkopfmodule können sehr einfach durch andere Bestückkopfmodule ausgetauscht werden. Sowohl die Montage als auch die Demontage eines Bestückkopfmoduls sind durch die genormten Schnittstellen des Rahmenelementes und der Bestückkopfmodule einfach durchzuführen. Ist ein Bestückkopfmodul defekt, kann dieses einfach, kostengünstig und schnell durch ein neues Bestückkopfmodul ausgetauscht werden. Es ist nicht mehr erforderlich, den gesamten Bestückkopf zu tauschen. Die identisch ausgebildeten Schnittstellen stellen ein einfaches Interface zum Bediener dar. Die Vereinfachung und Normung der Schnittstellen ist insbesondere deshalb vorteilhaft, da die Bestückkopfmodule aufgrund der hohen mechanischen Beanspruchung über die Lebensdauer sehr wartungsaufwendig sind und in ihrer Gesamtheit sich dem Bediener komplex darstellen.

Wie bereits zuvor ausgeführt sind vorzugsweise alle Schnittstellen des Rahmenelementes identisch ausgebildet. Dies ermöglicht, dass sämtliche Bestückkopfmodule ebenfalls genormt ausgebildet werden können. Genormt oder identisch ausgebildet im Zusammenhang mit den Bestückkopfmodulen bedeutet im Sinne der Erfindung, dass die äußeren Abmaße und die Anordnung der Schnittstellen bei allen Bestückkopfmodulen gleich ist, so dass diese einfach an die identisch ausgebildeten Schnittstellen des Rahmenelementes angeschlossen werden können. Es können je nach Bedarf ein oder mehrere Bestückkopfmodule von dem Bestückkopf demontiert und durch ein oder mehrere andere Bestückkopfmodule ersetzt werden.

Gemäß einer bevorzugten Weiterbildung der Erfindung kann bei dem Bestückkopf vorgesehen sein, dass jede Schnittstelle Teil einer Aufnahmeeinrichtung des Rahmenelementes ist, wobei jede Aufnahmeeinrichtung zur formschlüssigen Aufnahme jeweils eines Bestückkopfmoduls ausgebildet ist. Das heißt, das Rahmenelement weist zwei oder mehr Aufnahmeeinrichtungen auf, wobei jede Aufnahmeeinrichtung eine Schnittstelle zur Übertragung von Energie, Daten und/oder Luft aufweist. Die Schnittstellen weisen vorzugsweise Direktkontaktierungen mit Kontaktstiften für die Übertragung von Daten und Energie bzw. Kupplungen für die Luftversorgung auf. Die Übertragung von Daten und Energie kann auch kontaktlos erfolgen. Vorzugsweise sind die identisch ausgebildeten Schnittstellen des Rahmenelementes zur Übertragung von Energie, Daten und Luft ausgebildet. Hierdurch kann an jeder Schnittstelle jedes verschiedene Bestückkopfmodul angeschlossen werden. Es ist aber auch möglich, dass zwei oder mehrere Schnittstellen nur zur Übertragung von Energie und Daten ausgebildet sind. Die Aufnahmeeinrichtungen dienen zur formschlüssigen Aufnahme der Bestückkopfmodule, das heißt, zur Justierung aber auch zur Fixierung der Bestückkopfmodule. Durch die formschlüssige Aufnahme der Bestückkopfmodule in die Aufnahmeeinrichtungen werden die Bestückkopfmodule automatisch richtig an die entsprechenden Schnittstellen herangeführt, so dass die Schnittstellen der Bestückkopfmodule fluchtend zu den Schnittstellen des Rahmenelementes positioniert und entsprechend angeschlossen werden können.

Die Aufnahmeeinrichtungen zur formschlüssigen Aufnahme jeweils eines Bestückkopfmoduls sind vorzugsweise garagenförmig ausgebildet. Das heißt, die Aufnahmeeinrichtungen weisen vorteilhafterweise Seitenwände auf, die als Führungen zum Einführen eines Bestückkopfmoduls dienen. Hierdurch ist sichergestellt, dass die Bestückkopfmodule automatisch richtig in die Aufnahmeeinrichtungen eingeführt werden und richtig an den entsprechenden Schnittstellen des Rahmenelementes angeschlossen werden können.

Besonders bevorzugt ist es, wenn alle Aufnahmeeinrichtungen des Rahmenelementes identisch ausgebildete Aufnahmeräume aufweisen. Dies ermöglicht, dass alle Bestückkopfmodule genormte Außenmaße aufweisen können, so dass an jeder Aufnahmeeinrichtung jedes Bestückkopfmodul eingeführt und angeschlossen werden kann. Im Inneren können die Bestückkopfmodule selbstverständlich verschiedenartig ausgebildet sein.

Gemäß einer weiteren bevorzugten Weiterentwicklung der Erfindung kann bei dem Bestückkopf vorgesehen sein, dass die Aufnahmeeinrichtungen zur Fixierung der Bestückkopfmodule an dem Rahmenelement ausgebildet sind. Das bedeutet, jede Aufnahmeeinrichtung weist vorteilhafterweise Fixierelemente auf, um das vollständig in die Aufnahmeeinrichtung eingefügte Bestückkopfmodul sicher in dieser zu halten. Die Fixierelemente sind dabei derart ausgebildet, dass sie das vollständig eingeführte Bestückkopfmodul, das an die Schnittstelle des Rahmenelementes angeschlossen ist, sicher halten. Vorzugsweise können die Fixierelemente Rasteinrichtungen und/oder Steckverbindungen aufweisen, so dass eine einfache Fixierung eines Bestückkopfmoduls an einer Aufnahmeeinrichtung ermöglicht wird. Insbesondere sind einfache Fixierelemente bevorzugt, so dass die Demontage eines Bestückkopfmoduls an einer Aufnahmeeinrichtung einfach vonstattengehen kann. Beispielsweise kann ein Fixierelement als ein Deckelelement ausgebildet sein, das verschwenk- und/oder verdrehbar an der Aufnahmeeinrichtung angeordnet ist.

Bevorzugt ist ferner ein Bestückkopf, bei dem wenigstens eine Aufnahmeeinrichtung des Rahmenelementes ein-, zwei- und/oder dreidimensional verschiebbar an dem Rahmenelement angeordnet ist. So kann eine Aufnahmeeinrichtung in z-Richtung, das heißt in Richtung zu einem Substrat, bewegbar sein. In einer besonders bevorzugten Ausführungsvariante des Bestückkopfes kann eine Aufnahmeeinrichtung des Rahmenelementes in x-Richtung, in y-Richtung und in z-Richtung verschiebbar an dem Rahmenelement angeordnet sein. Hierdurch ist der Bestückkopf besonders flexibel mit Bestückkopfmodulen konfigurierbar. Vorzugsweise sind entsprechende Führungselemente, insbesondere Linearführungen, an jeder Aufnahmeeinrichtung vorgesehen, entlang derer ein Bestückkopfmodul in den Aufnahmeraum einer Aufnahmeeinrichtung formschlüssig einführbar ist, bis die Schnittstelle des Bestückkopfmoduls mit der Schnittstelle des Rahmenelementes beziehungsweise der Aufnahmeeinrichtung verbunden ist.

Die wenigstens eine verschiebbar an dem Rahmenelement angeordnete Aufnahmevorrichtung kann beispielsweise manuell verschoben werden. Besonders bevorzugt ist ein Bestückkopf, bei dem die wenigstens eine verschiebbar angeordnete Aufnahmeeinrichtung durch eine oder mehrere Antriebseinheiten, insbesondere durch einen oder mehrere Linearmotor(en), verschiebbar ist.

Gemäß einer weiteren bevorzugten Weiterentwicklung der Erfindung kann bei dem Bestückkopf vorgesehen sein, dass jede Aufnahmeeinrichtung ein Verriegelungselement zur Fixierung eines Bestückkopfmoduls an der Aufnahmeeinrichtung aufweist. Das heißt, ein formschlüssig in einer Aufnahmeeinrichtung eingeführtes Bestückkopfmodul wird in seiner Endposition in dem Aufnahmeraum der Aufnahmeeinrichtung fixiert, so dass das Bestückkopfmodul sicher in der Aufnahmeeinrichtung bzw. an dem Rahmenelement fixiert ist. Das Verriegelungselement kann verschiedenartig ausgebildet sein. Beispielsweise können Rast-, Schnapp- oder Steckelemente vorgesehen sein. Ferner kann zur Fixierung eines Bestückkopfmoduls ein verschwenk- und/oder verdrehbarer Deckel vorgesehen sein. Die Fixierung kann vorteilhafterweise auch durch Schraubverbindungen erfolgen.

Ferner kann gemäß einer bevorzugten Ausführungsform des Bestückkopfes bei dem Bestückkopf vorgesehen sein, dass das Rahmenelement an einer ein- oder zweidimensional verschiebbaren Trägereinrichtung befestigt ist. Diese Trägereinrichtung, häufig auch nur als Träger bezeichnet, ist vorzugsweise parallel zu dem auf einer Transporteinrichtung eines Bestückautomaten transportierten Substrat bewegbar. So kann die Trägereinrichtung beispielsweise ein- oder zweidimensional, das heißt in x-Richtung und/oder in y-Richtung, bewegbar sein. Vorzugsweise ist die Fixierung des Rahmenelementes an der Trägereinrichtung durch einfache Befestigungsmittel realisiert, so dass eine schnelle Montage bzw. Demontage des Rahmenelementes an beziehungsweise von der Trägereinrichtung ermöglicht wird.

Die Bestückkopfmodule können verschiedenartig ausgebildet sein. So kann ein Bestückkopfmodul als Aktorelement oder als Sensorelement ausgebildet sein. Ein Bestückkopfmodul kann beispielsweise für einen sogenannten Speedbereich ausgebildet sein. Derartige Bestückkopfmodule sind zur schnellen Bestückung eines Substrates, insbesondere einer Leiterplatte, ausgebildet. Ferner kann ein Bestückkopfmodul für einen sogenannten Flexbereich ausgebildet sein. Derartige Bestückkopfmodule sind zur variablen Bestückung eines Substrates, insbesondere einer Leiterplatte, ausgebildet. Beispielsweise kann ein Aktorelement ein sogenanntes Pick & Place Modul sein. Ein Sensorelement kann beispielsweise zur automatischen optischen Inspektion (AOI) ausgebildet sein. Des Weiteren kann ein Sensorelement optische Messfunktionen aufweisen. Ebenso kann ein Bestückkopfmodul als Greifer oder als Dispenser für Klebstoff oder Flussmittel ausgebildet sein. Durch die genormte Größe der Aufnahmeeinrichtungen beziehungsweise der Aufnahmeräume der Aufnahmeeinrichtungen des Rahmenelementes kann ein Kunde durch Auswahl und Konfiguration der entsprechenden Bestückkopfmodule einen Bestückkopf sehr einfach und schnell individuell anpassen. Durch die Kapselung der Funktionen der einzelnen Bestückkopfmodule ist bei Fehlern oder im Servicefall ein Problem am Bestückkopf klar detektierbar, so dass das entsprechend fehlerhafte Bestückkopfmodul einfach ausgetauscht werden kann. Vorzugsweise weist jedes Bestückkopfmodul eine entsprechende Elektronik auf. Das heißt, bevorzugt ist ein Bestückkopf, bei dem jedes Bestückkopfmodul eine eigene Elektronik und eine eigene Steuereinheit zur Ansteuerung der Elektronik des jeweiligen Bestückkopfmoduls aufweist. Alternativ dazu kann der Bestückkopf, insbesondere das Rahmenelement, eine zentrale Steuereinheit zur Ansteuerung der Elektroniken von wenigstens zwei Bestückkopfmodulen aufweisen. Diese zentrale Lösung ermöglicht, dass die Bestückkopfmodule einfacher ausgebildet werden können. Vorteilhafterweise kann eine zentrale Steuereinheit an dem Bestückkopf, insbesondere an dem Rahmenelement, für alle an dem Rahmenelement anschließbare Bestückkopfmodule vorgesehen sein. Vorteilhaft ist ferner bei dem Bestückkopf, wenn die Elektronik eines jeden Bestückkopfmoduls zur Speicherung des Typs, von Kalibrierungsdaten, des Fertigungsdatums des technischen Standes und/oder der geleisteten Zyklenzahlen des Bestückkopfmoduls ausgebildet ist. Die Elektronik eines Bestückkopfmoduls kann ferner zur Speicherung weiterer Daten und Informationen ausgebildet sein. Durch die leichte Austauschbarkeit der Bestückkopfmodule von dem Rahmenelement beziehungsweise den Aufnahmeeinrichtungen des Rahmenelementes kann die Stillstandzeit eines Bestückkopfes reduziert werden. Genormte Bestückkopfmodule sowie ein derartig ausgebildeter Bestückkopf ermöglichen eine sehr kurze Reparaturzeit bei einem Servicefall, da die Komplexität des Bestückkopfes in kleine Einheiten aufgeteilt und gekapselt ist.

Ferner kann gemäß einer bevorzugten Weiterentwicklung der Erfindung bei einem Bestückkopf vorgesehen sein, dass zur Fixierung der Bestückkopfmodule an den Aufnahmeeinrichtungen jede Aufnahmeeinrichtung Befestigungselemente zur lösbaren Befestigung eines Bestückkopfmoduls über komplementär ausgebildete Gegenbefestigungselemente des Bestückkopfmoduls aufweist, wobei die Befestigungselemente als Rast-, Steck- und/oder Bajonettverschlusselemente ausgebildet sind. Derartige Befestigungselemente ermöglichen eine einfache und insbesondere schnelle Befestigung eines Bestückkopfmoduls an einer Aufnahmeeinrichtung eines Rahmenelementes. Hierdurch ist neben der einfachen Montage eines Bestückkopfmoduls an einer Aufnahmeeinrichtung auch eine einfache und schnelle Demontage des Bestückkopfmoduls an der Aufnahmeeinrichtung gewährleistet. Hierdurch kann ein Bestückkopfmodul einfach und schnell durch ein anderes Bestückkopfmodul ausgetauscht werden, ohne dass der gesamte Bestückkopf ausgetauscht werden muss. Durch die einfache und schnelle Austauschmöglichkeit einzelner Bestückkopfmodul ist die Flexibilität des Bestückkopfes erhöht.

Bevorzugt sind die Befestigungselemente als Rast- oder Steckelemente ausgebildet. Durch die Verwendung von Rast- oder Steckelementen kann eine schnelle Befestigung eines Bestückkopfmoduls an einer Aufnahmeeinrichtung erfolgen, wobei das Bestückkopfmodul komplementäre Gegenbefestigungselemente aufweist. Vorzugsweise sind die Rast- oder Steckelementen der Aufnahmeeinrichtungen als Rastaufnahmen beziehungsweise Steckaufnahmen ausgebildet. Die Schnellwechselbarkeit eines Bestückkopfmoduls von einer Aufnahmeeinrichtung wird dadurch ermöglicht, dass die Aufnahmeeinrichtung und die Bestückkopfmodule insbesondere komplementäre und lagedefinierte, also feste, Befestigungsschnittstellen und lagedefinierte Schnittstellen zur Übertragung von Energie, Daten und/oder Luft aufweisen. Die Befestigungselemente der Aufnahmeeinrichtungen stellen zusammen mit den Gegenbefestigungselementen der Bestückkopfmodule sogenannte Schnellkupplungen dar, die eine einfache und schnelle Befestigung der Bestückkopfmodule an den Aufnahmeeinrichtungen, aber auch ein schnelles und einfaches Lösen der Bestückkopfmodule von den Aufnahmeeinrichtungen ermöglichen.

Ferner kann gemäß einer bevorzugten Weiterentwicklung der Erfindung bei einem Bestückkopf vorgesehen sein, dass die Schnittstellen einer Aufnahmeeinrichtung und die Befestigungselemente der einen Aufnahmeeinrichtung derart an der Aufnahmeeinrichtung angeordnet sind, dass die Befestigung eines Bestückkopfmoduls an die Schnittstellen und an die Befestigungselemente der Aufnahmeeinrichtung durch Aufstecken oder Aufschieben des Bestückkopfmoduls entlang einer Befestigungsrichtung, insbesondere einer geradlinigen Befestigungsrichtung, ermöglicht ist. Ein Vorteil eines derartig ausgebildeten Bestückkopfes ist, dass wenig Bauraum beziehungsweise Montageraum zur physischen Befestigung der Bestückkopfmodule an die Aufnahmeeinrichtungen, als auch zum Anschluss an die Schnittstellen zur Übertragung von Energie, Daten und/oder Luft zu den Bestückkopfmodulen erforderlich ist. Die Befestigungselemente als auch die Schnittstellen der Aufnahmeeinrichtungen bedingen vorteilhafterweise die gleiche Befestigungsrichtung der Bestückkopfmodule. Das heißt, jedes Bestückkopfmodul kann entlang einer Befestigungsrichtung, insbesondere einer geradlinigen Befestigungsrichtung, in eine entsprechende Aufnahmeeinrichtung eingeführt werden, wobei gleichzeitig die physische Befestigung des Bestückkopfmoduls an die Befestigungselemente der Aufnahmeeinrichtung, als auch der Anschluss an die Schnittstellen zur Übertragung von Energie, Daten und/oder Luft erfolgt. Dies spart erheblichen Montageaufwand, als auch Montagezeit zur Montage und auch Demontage eines Bestückkopfmoduls an eine beziehungsweise von einer Aufnahmeeinrichtung. Ferner ermöglicht ein derartig ausgebildeter Bestückkopf, insbesondere durch die formschlüssige Aufnahme, eine automatische Zentrierung eines Bestückkopfmoduls an einer Aufnahmeeinrichtung, ohne dass dafür zusätzliche Handhabungen erforderlich sind. Sowohl die Befestigungselemente der Aufnahmeeinrichtung, als auch die Schnittstellen für Energie, Daten und/oder Luft können bei einer derartigen Befestigung der Bestückkopfmodul entlang einer geradlinigen Befestigungsrichtung auf einem engen Bauraum untergebracht werden. Ein derartiger Bestückkopf lässt sich mit wenigen Handgriffen schnell an unterschiedliche Bestückaufgaben anpassen, ohne dafür aus dem Bestückautomaten ausgebaut werden zu müssen.

Ferner kann gemäß einer bevorzugten Weiterentwicklung der Erfindung bei einem Bestückkopf vorgesehen sein, dass jede Aufnahmeeinrichtung Verstellmittel zur Verschiebung eines aufgenommenen Bestückkopfmoduls zur ein-, zwei- und/oder dreidimensionalen Verschiebung des aufgenommenen Bestückkopfmoduls relativ zu der Aufnahmeeinrichtung aufweist. Alternativ oder zusätzlich zu der Verschiebbarkeit der Aufnahmeeinrichtungen an dem Rahmenelement, können die Aufnahmeeinrichtungen Verstellmittel aufweisen, die ermöglichen, dass ein aufgenommenes Bestückkopfmodul innerhalb einer Aufnahmeeinrichtung in eine x-, eine y- und/oder eine z-Richtung bewegt werden kann, ohne die sichere Befestigung und den Anschluss an die Schnittstellen für Energie, Daten und/oder Luft zu verlieren. Die Verstellmittel können beispielsweise Führungsschienen mit Verrastungen sein.

Gemäß dem zweiten Aspekt der Erfindung wird die Aufgabe durch einen Bestückautomaten zum Bestücken von Substraten mit den Bauelementen gelöst, wobei der Bestückautomat zumindest einen Bestückkopf gemäß dem ersten Aspekt der Erfindung aufweist. Ein derartig ausgebildeter Bestückautomat ist besonders flexibel und ermöglicht eine geringe Stillstandzeit bei einem Fehlerfall in dem zumindest einen Bestückkopf.

Gemäß dem dritten Aspekt der Erfindung wird die Aufgabe durch ein Bestückverfahren zum Bestücken von Substraten gelöst, bei dem ein Bestückkopf gemäß dem ersten Aspekt der Erfindung verwendet wird. Die Verwendung eines Bestückkopfes gemäß dem ersten Aspekt der Erfindung ermöglicht ein schnelles und einfaches Durchführen eines Bestückverfahrens. Insbesondere ist eine schnelle Fehlerbehebung, Wartung und Umkonfiguration des Bestückkopfes zu geänderten Bestückaufträgen oder Applikationen durch die Verwendung eines derartigen Bestückkopfes möglich.

Die Erfindung und ihre Weiterbildungen sowie deren Vorteile werden nachfolgend anhand von Zeichnungen näher erläutert. Es zeigen jeweils schematisch:
Figur 1 in einer Schnittdarstellung ein Rahmenelement eines Bestückkopfes mit drei Aufnahmeeinrichtungen zur Aufnahme von Bestückkopfmodulen;
Figur 2 in einer Seitenansicht ein Rahmenelement mit einem fixierten Bestückkopfmodul;
Figur 3 in einer Schnittdarstellung ein weiteres Rahmenelement eines Bestückkopfes, wobei eine der drei Aufnahmeeinrichtungen verschiebbar ausgebildet ist;
Figur 4 in einer Seitenansicht eine verschiebbar gelagerte Aufnahmeeinrichtung eines Rahmenelementes, wobei ein Bestückkopfmodul an der verschiebbar gelagerten Aufnahmeeinrichtung fixiert ist.

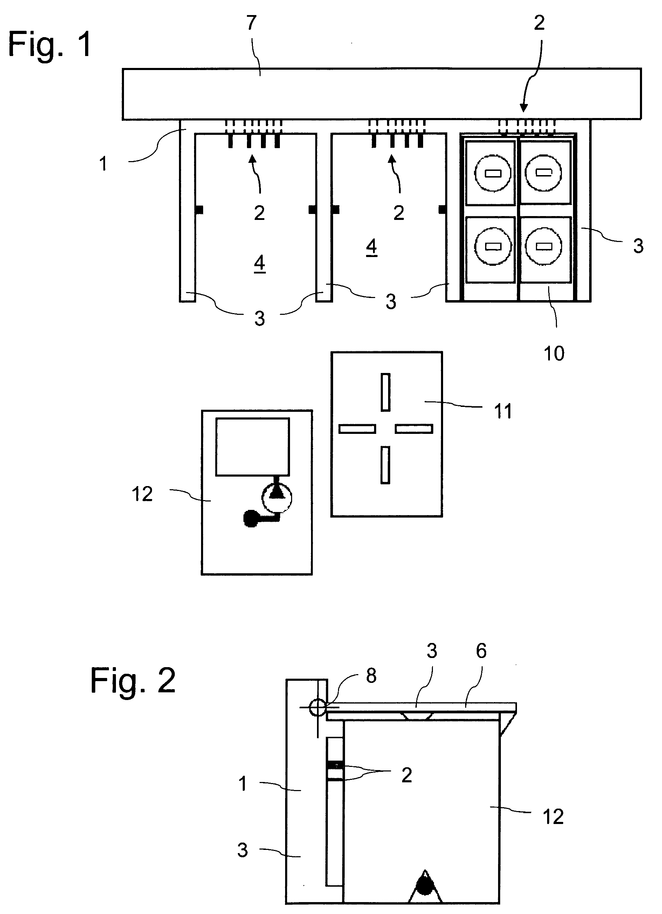

Elemente mit gleicher Funktion und Wirkungsweise sind in den Figuren 1 - 4 jeweils mit denselben Bezugszeichen versehen.

In der Figur 1 ist in einer schematischen Schnittdarstellung ein Rahmenelement 1 eines Bestückkopfes, der nach dem erfindungsgemäßen Konstruktionsprinzip ausgebildet ist, gezeigt. Das Rahmenelement 1 ist zur Befestigung von Bestückkopfmodulen 10, 11, 12 die insbesondere als Aktorelemente oder als Sensorelemente ausgebildet sind, ausgebildet. Das Rahmenelement 1 weist drei Schnittstellen 2 auf, die jeweils zur Übertragung von Energie, Daten und Luft zu jeweils einem Bestückkopfmodul 10, 11, 12 ausgebildet sind. Alle drei Schnittstellen 2 des Rahmenelementes 1 sind identisch ausgebildet. Das Rahmenelement 1 weist drei Aufnahmeeinrichtungen 3 auf, die jeweils einen Aufnahmeraum 4 zur Aufnahme eines Bestückkopfmoduls 10, 11, 12 aufweisen. Die Aufnahmeeinrichtungen 3 bzw. die Aufnahmeräume 4 der Aufnahmeeinrichtungen 3 sind identisch ausgebildet, so dass die einführbaren Bestückkopfmodule 10, 11, 12 genormt werden können. Das heißt, die Bestückkopfmodule 10, 11, 12 sind von ihren äußeren Abmaßen gleich groß ausgebildet, so dass jedes Bestückkopfmodul 10, 11, 12 in jede Aufnahmeeinrichtung 3 formschlüssig einschiebbar ist und mit den Schnittstellen 2 des Rahmenelementes 1 einfach verbindbar ist. In Fig. 1 sitzt das Bestückkopfmodul 10 in der, aus Sicht des Betrachters rechten Aufnahmeeinrichtung 3 der drei Aufnahmeeinrichtungen 3, während die Bestückkopfmodule 11, 12 vor den entsprechenden Aufnahmeeinrichtungen 3 angeordnet sind. Das Rahmenelement 1 ist an einer Trägereinrichtung 7 des Bestückkopfes befestigt. Die Trägereinrichtung 7 ist vorzugsweise parallel zu dem auf einer Transporteinrichtung transportierten Substrat bewegbar.

Figur 2 zeigt schematisch in einer Seitenansicht ein an einem Rahmenelement 1 befestigtes Bestückkopfmodul 12. Zur Fixierung des Bestückkopfmoduls 12 an dem Rahmenelement 1 bzw. an der Aufnahmeeinrichtung 3 des Rahmenelementes 1 ist ein Verriegelungselement 6, hier in Form eines Deckelelementes, vorgesehen, welches das Bestückkopfmodul 12 in seiner Endposition, in der es mit der Schnittstelle 2 des Rahmenelementes 1 verbunden ist, fixiert. Das Verriegelungselement 6 weist vorteilhafterweise Rastelemente zum Umgreifen des Bestückkopfmoduls 12 auf. Das Deckelelement 6 ist um eine Achse 8 verschwenkbar an der Aufnahmeeinrichtung 3 des Rahmenelementes 1 gehalten.

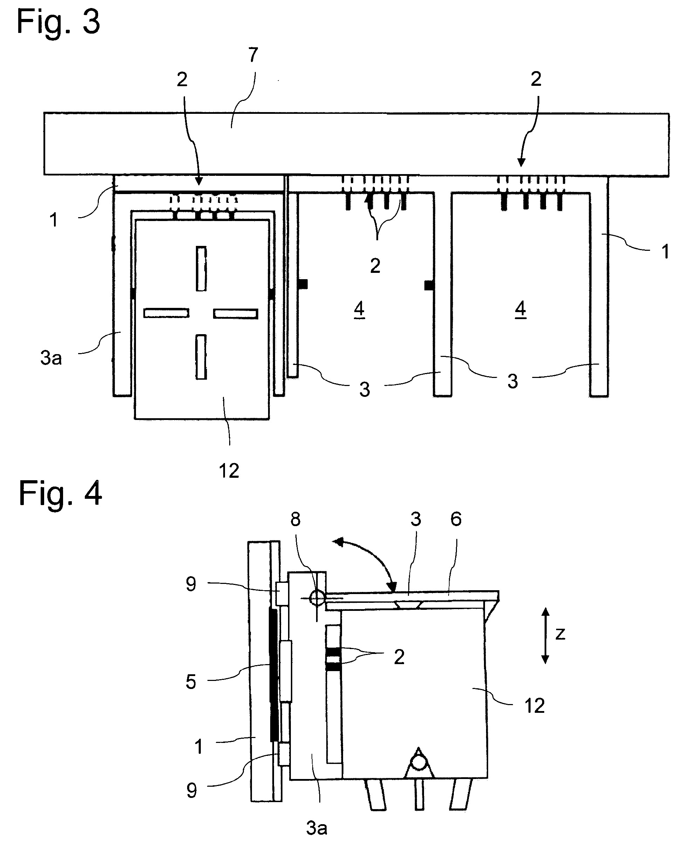

In der Figur 3 ist ein anderes Rahmenelement 1 eines Bestückkopfes in einer schematischen Schnittdarstellung gezeigt. Das Rahmenelement 1 weist drei Aufnahmeeinrichtungen 3 zur Aufnahme von Bestückkopfmodulen 12 auf. Die Aufnahmeeinrichtungen 3 bzw. die Aufnahmeräume 4 der Aufnahmeeinrichtungen 3 sowie die Schnittstellen 2 des Rahmenelementes 1 beziehungsweise der einzelnen Aufnahmeeinrichtungen 3 sind identisch ausgebildet, so dass in jede Aufnahmeeinrichtung 3 ein beliebiges Bestückkopfmodul 10, 11, 12 einführbar ist. Im Vergleich zu dem Rahmenelement 1 gemäß Figur 1 weist das Rahmenelement 1 der Figur 3 eine verschiebbare Aufnahmeeinrichtung 3a auf. Das heißt, zwei Aufnahmeeinrichtungen 3 sind unbeweglich an dem Rahmenelement 1 angeordnet, währenddessen eine dritte Aufnahmeeinrichtung 3a in z-Richtung bewegbar an dem Rahmenelement angeordnet ist. Die unbeweglichen Aufnahmeeinrichtungen 3 sind vorzugsweise einstückig mit dem Rahmenelement 1 ausgebildet. Die verschiebbare Aufnahmeeinrichtung 3a ist über Lager 9 an dem Rahmenelement 1 verschiebbar gehalten. Eine verschiebbare Aufnahmeeinrichtung 3a ist insbesondere dann von Nutzen, wenn unterschiedliche Konfigurationen des Bestückkopfes erforderlich sind und sich daraus unterschiedliche z-Hübe/Level ergeben.

Die verschiebbare Anordnung der Aufnahmeeinrichtung 3a an dem Rahmenelement 1 ist in Figur 4 schematisch in einer Seitenansicht dargestellt. Die Aufnahmeeinrichtung 3a ist an dem Rahmenelement 1 verschiebbar gelagert. Vorzugsweise kann die Aufnahmeeinrichtung 3a durch Antriebseinheit 5, insbesondere elektrische Antriebe, wie einem Linearmotor, in z-Richtung rauf- oder runtergefahren werden. Das Deckelelement 6 ist um eine Achse 8 verschwenkbar an der Aufnahmeeinrichtung 3a gehalten.

Allgemein betrachtet können die die Bestückkopfmodule verschiedenartig ausgebildet sein. Vorzugsweise ist in den Bestückkopfmodulen eine entsprechende Elektronik integriert. Über die Schnittstellen des Rahmenelementes können die verschiedenartig ausgebildeten Bestückkopfmodule mit Daten, Luft und Energie versorgt werden. Ein Bestückkopfmodul kann beispielsweise zur automatischen optischen Inspektion (AOI) ausgebildet sein. Ein derartiges Bestückkopfmodul kann mittels geeigneter Bildverarbeitungsverfahren Fehler an einem zu bestückenden Bauelement oder an der Positionierung eines Bauelementes an dem Substrat finden.

### Bezugszeichenliste

- 1: Rahmenelement
- 2: Schnittstellen des Rahmenelementes
- 3: Aufnahmeeinrichtung
- 4: Aufnahmeräume
- 5: Antriebseinheit
- 6: Verriegelungselement / Deckelelement
- 7: Trägereinrichtung
- 8: Drehachse des Deckelelementes
- 9: Lagerung
- 10: Bestückkopfmodul
- 11: Bestückkopfmodul
- 12: Bestückkopfmodul

## Patentansprüche

1. Bestückkopf für einen Bestückautomaten zum Bestücken von Substraten mit Bauelementen, wobei der Bestückkopf ein Rahmenelement (1) zur Befestigung von Bestückkopfmodulen (10, 11, 12) aufweist, wobei das Rahmenelement (1) zwei oder mehrere Schnittstellen (2) aufweist, die jeweils zur Übertragung von Energie, Daten und/oder Luft zu jeweils einem Bestückkopfmodul (10, 11, 12) ausgebildet sind, wobei alle Schnittstellen (2) des Rahmenelementes (1) identisch ausgebildet sind, wobei jede Schnittstelle (2) Teil einer Aufnahmeeinrichtung (3) des Rahmenelementes (1) ist, wobei jede Aufnahmeeinrichtung (3) zur formschlüssigen Aufnahme jeweils eines Bestückkopfmoduls (10, 11, 12) ausgebildet ist, wobei alle Aufnahmeeinrichtungen (3) identisch ausgebildete Aufnahmeräume (4) aufweisen, und wobei die Aufnahmeeinrichtungen (3) jeweils sowohl zur Aufnahme von einem als ein Aktorelement als auch zur Aufnahme von einem als ein Sensorelement ausgebildeten Bestückkopfmodul (10,11,12) ausgebildet sind.

2. Bestückkopf nach Anspruch 1, **dadurch gekennzeichnet, dass** die Aufnahmeeinrichtungen (3) zur Fixierung der Bestückkopfmodule (10, 11, 12) an dem Rahmenelement (1) ausgebildet sind.

3. Bestückkopf nach mindestens einem der vorhergehenden Ansprüche 1 bis 2, **dadurch gekennzeichnet, dass** wenigstens eine Aufnahmeeinrichtung (3) des Rahmenelementes (1) ein-, zwei- und/oder dreidimensional verschiebbar an dem Rahmenelement (1) angeordnet ist.

4. Bestückkopf nach Anspruch 3, **dadurch gekennzeichnet, dass** die wenigstens eine verschiebbar angeordnete Aufnahmeeinrichtung (3a) durch eine oder mehrere Antriebseinheiten (5), insbesondere einen oder mehrere Linearmotoren, verschiebbar ist.

5. Bestückkopf nach mindestens einem der vorhergehenden Ansprüche 1 bis 4, **dadurch gekennzeichnet, dass** jede Aufnahmeeinrichtung (3) ein Verriegelungselement (6) zur Fixierung eines Bestückkopfmoduls (10, 11, 12) an der Aufnahmeeinrichtung (3) aufweist.

6. Bestückkopf nach mindestens einem der vorhergehenden Ansprüche 1 bis 5, **dadurch gekennzeichnet, dass** das Rahmenelement (1) an einer ein- oder zweidimensional verschiebbaren Trägereinrichtung (7) befestigt ist.

7. Bestückkopf nach mindestens einem der vorhergehenden Ansprüche 1 bis 6, **dadurch gekennzeichnet, dass** jedes Bestückkopfmodul (10, 11, 12) eine Elektronik und eine Steuereinheit zur Ansteuerung der Elektronik des Bestückkopfmoduls (10, 11, 12) oder das der Bestückkopf, insbesondere das Rahmenelement (1), eine zentrale Steuereinheit zur Ansteuerung der Elektroniken von wenigstens zwei Bestückkopfmodulen (10, 11, 12) aufweist.

8. Bestückkopf nach Anspruch 7, **dadurch gekennzeichnet, dass** die Elektronik eines jeden Bestückkopfmoduls (10, 11, 12) zur Speicherung des Typs, von Kalibrierungsdaten, des Fertigungsdatums, des technischen Standes und/oder der geleisteten Zyklenzahlen des Bestückkopfmoduls (10, 11, 12) ausgebildet ist.

9. Bestückkopf nach mindestens einem der vorhergehenden Ansprüche 2 bis 8, **dadurch gekennzeichnet, dass** zur Fixierung der Bestückkopfmodule (10, 11, 12) an den Aufnahmeeinrichtungen (3) jede Aufnahmeeinrichtung (3) Befestigungselemente zur lösbaren Befestigung eines Bestückkopfmoduls (10, 11, 12) über komplementär ausgebildete Gegenbefestigungselemente des Bestückkopfmoduls (10, 11, 12) aufweist, wobei die Befestigungselemente als Rast-, Steck- und/oder Bajonettverschlusselemente ausgebildet sind.

10. Bestückkopf nach Anspruch 9, **dadurch gekennzeichnet, dass** die Schnittstellen (2) einer Aufnahmeeinrichtung (3) und die Befestigungselemente der einen Aufnahmeeinrichtung (3) derart an der Aufnahmeeinrichtung (3) angeordnet sind, dass die Befestigung eines Bestückkopfmoduls (10, 11, 12) an die Schnittstellen (2) und an die Befestigungselemente der Aufnahmeeinrichtung (3) durch Aufstecken oder Aufschieben des Bestückkopfmoduls (10, 11, 12) entlang einer Befestigungsrichtung, insbesondere einer geradlinigen Befestigungsrichtung, ermöglicht ist.

11. Bestückkopf nach mindestens einem der vorhergehenden Ansprüche 1 bis 10, **dadurch gekennzeichnet, dass** jede Aufnahmeeinrichtung (3) Verstellmittel zur Verschiebung eines aufgenommenen Bestückkopfmoduls (10, 11, 12) zur ein-, zwei- und/oder dreidimensionalen Verschiebung des aufgenommenen Bestückkopfmoduls (10, 11, 12) relativ zu der Aufnahmeeinrichtung (3) aufweist.

12. Bestückautomat zum Bestücken von Substraten mit Bauelementen, welcher zumindest einen Bestückkopf nach einem der vorhergehenden Ansprüche 1 bis 11 aufweist.

13. Bestückverfahren zum Bestücken von Substraten mit Bauelementen, bei dem ein Bestückkopf nach einem der vorhergehenden Ansprüche 1 bis 11 verwendet wird.

## Claims

1. A placement head for a placement machine for equipping substrates with components, wherein the placement head comprises a frame element (1) for fastening placement head modules (10, 11, 12), wherein the frame element (1) comprises two or more interfaces (2), which are each constituted for the transmission of energy, data and/or air in each case to the placement head module (10, 11, 12), wherein all the interfaces (2) of the frame element (1) are constituted identical, wherein each interface (2) is part of an accommodation arrangement (3) of the frame element (1), wherein each accommodation arrangement (3) is constituted for the form-fit accommodation of in each case one placement head module (10, 11, 12), wherein all the accommodation arrangements (3) comprise identically constituted accommodation spaces (4), and wherein the accommodation arrangements (3) are each constituted both for the accommodation of a placement head module (10, 11, 12) constituted as an actuator element as well as for the accommodation of a placement head module (10, 11, 12) constituted as a sensor element.

2. The placement head according to claim 1, **characterised in that** the accommodation arrangements (3) are constituted for the fixing of the placement head modules (10, 11, 12) to the frame element (1).

3. The placement head according to at least one of preceding claims 1 to 2, **characterised in that** at least one accommodation arrangement (3) of the frame element (1) is disposed one-dimensionally, two-dimensionally and/or three-dimensionally displaceable on the frame element (1).

4. The placement head according to claim 3, **characterised in that** the at least one displaceably disposed accommodation arrangement (3a) is displaceable by means of one or more drive units (5), in particular one or more linear motors.

5. The placement head according to at least one of preceding claims 1 to 4, **characterised in that** each accommodation arrangement (3) comprises a locking element (6) for fixing a placement head module (10, 11, 12) to the accommodation arrangement (3).

6. The placement head according to at least one of preceding claims 1 to 5, **characterised in that** the frame element (1) is fastened to a one-dimensionally or two-dimensionally displaceable carrier arrangement (7).

7. The placement head according to at least one of preceding claims 1 to 6, **characterised in that** each placement head module (10, 11, 12) comprises electronics and a control unit for controlling the electronics of the placement head module (10, 11, 12) or that the placement head, in particular the frame element (1), comprises a central control unit for controlling the electronics of at least two placement head modules (10, 11, 12).

8. The placement head according to claim 7, **characterised in that** the electronics of each placement head module (10, 11, 12) is constituted for storing the type, calibration data, the date of manufacture, the technical status and/or the performed number of cycles of the placement head module (10, 11, 12).

9. The placement head according to at least one of preceding claims 2 to 8, **characterised in that**, for the fixing of the placement head modules (10, 11, 12) to the accommodation arrangements (3), each accommodation arrangement (3) comprises fastening elements for the detachable fastening of a placement head module (10, 11, 12) by means of complementary counter-fastening elements of the placement head module (10, 11, 12), wherein the fastening elements are constituted as catch, plug-in and/or bayonet-lock elements.

10. The placement head according to claim 9, **characterised in that** the interfaces (2) of an accommodation arrangement (3) and the fastening elements of the one accommodation arrangement (3) are disposed on the accommodation arrangement (3) in such a way that the fastening of a placement head module (10, 11, 12) to the interfaces (2) and to the fastening elements of the accommodation arrangement (3) is enabled by plugging- on or pushing-on of the placement head module (10, 11, 12) along a fastening direction, in particular a rectilinear fastening direction.

11. The placement head according to at least one of preceding claims 1 to 10, **characterised in that** each accommodation arrangement (3) comprises adjustment means for the displacement of an accommodated placement head module (10, 11, 12), for the one-dimensional, two-dimensional and/or three-dimensional displacement of the accommodated placement head module (10, 11, 12), relative to the accommodation arrangement (3).

12. A placement machine for equipping substrates with components, which comprises at least one placement head according to any one of preceding claims 1 to 11.

13. A placement method for equipping substrates with components, wherein a placement head according to any one of preceding claims 1 to 11 is used.

## Revendications

1. Tête à implanter pour un automate d'alimentation pour l'implantation de substrats avec des composants, la tête à implanter comportant un élément de cadre (1) pour fixer des modules de tête à implanter (10, 11, 12), l'élément de cadre (1) comportant deux ou plusieurs interfaces (2) qui sont respectivement constituées pour transmettre de l'énergie, des données et/ou de l'air à respectivement un module de tête à implanter (10, 11, 12), toutes les interfaces (2) de l'élément de cadre (1) étant constituées de manière identique, chaque interface (2) étant partie d'un dispositif de réception (3) de l'élément de cadre (1), chaque dispositif de réception (3) étant constitué pour recevoir respectivement par conformité de forme un module de tête à implanter (10, 11, 12), tous les dispositifs de réception (3) comportant des espaces de réception (4) constitués de manière identique et les dispositifs de réception (3) étant respectivement constitués tant pour recevoir un module de tête à implanter (10, 11, 12) constitué comme un élément d'actionneur que pour recevoir également un module de tête à implanter constitué comme un élément de détection.

2. Tête à implanter selon la revendication 1 **caractérisée en ce que** les dispositifs de réception (3) sont constitués pour fixer les modules de tête à implanter (10, 11, 12) sur l'élément de cadre (1).

3. Tête à implanter selon au moins l'une quelconque des revendications précédentes 1 à 2 **caractérisée en ce qu'**au moins un dispositif de réception (3) de l'élément de cadre (1) est disposé pouvant être mobile sur l'élément de cadre (1) de manière uni-, bi- et/ou tridimensionnelle.

4. Tête à implanter selon la revendication 3 **caractérisée en ce qu'**au moins un dispositif de réception (3a) disposé pouvant être mobile, peut être déplacé par une ou plusieurs unités d'entraînement (5), en particulier un ou plusieurs moteurs linéaires.

5. Tête à implanter selon au moins l'une quelconque des revendications précédentes 1 à 4 **caractérisée en ce que** chaque dispositif de réception (3) comporte un élément de verrouillage (6) pour fixer un module de tête à implanter (10, 11, 12) sur le dispositif de réception (3).

6. Tête à implanter selon au moins l'une quelconque des revendications précédentes 1 à 5 **caractérisée en ce que** l'élément de cadre (1) est fixé à un dispositif de support (7) pouvant être mobile de manière uni- ou bidimensionnelle.

7. Tête à implanter selon au moins l'une quelconque des revendications précédentes 1 à 6 **caractérisée en ce que** chaque module de tête à implanter (10, 11, 12) comporte un système électronique et une unité de commande pour piloter le système électronique du module de tête à implanter (10, 11, 12) ou **en ce que** la tête à implanter, en particulier l'élément de cadre (1) comporte une unité de commande centrale pour piloter les systèmes électroniques d'au moins deux modules de tête à implanter (10, 11, 12).

8. Tête à implanter selon la revendication 7 **caractérisée en ce que** le système électronique de chaque module de tête à implanter (10, 11, 12) est constitué pour mémoriser le type, des caractéristiques d'étalonnage, la date de fabrication, l'état technique et/ou les nombres de cycles assurés du module de tête à implanter (10, 11, 12).

9. Tête à implanter selon au moins l'une quelconque des revendications précédentes 2 à 8 **caractérisée en ce que** pour fixer les modules de tête à implanter (10, 11, 12) sur les dispositifs de réception (3), chaque dispositif de réception (3) comporte des éléments de fixation pour la fixation amovible d'un module de tête à implanter (10, 11, 12) sur des éléments de contre-fixation du module de tête à implanter (10, 11, 12) constitués de manière complémentaire, les éléments de fixation étant constitués comme des éléments de fermeture à crans, connectables et/ou à baïonnette.

10. Tête à implanter selon la revendication 9 **caractérisée en ce que** les interfaces (2) d'un dispositif de réception (3) et les éléments de fixation d'un dispositif de réception (3) sont disposés sur le dispositif de réception (3) de telle manière que la fixation d'un module de tête à implanter (10, 11, 12) sur les interfaces (2) et sur les éléments de fixation du dispositif de réception (3) est possible par emboîtement ou glissement du module de tête à implanter (10, 11, 12) le long d'un dispositif de fixation, en particulier d'un dispositif de fixation rectiligne.

11. Tête à implanter selon au moins une quelconque des revendications précédentes 1 à 10 **caractérisée en ce que** chaque dispositif de réception (3) comporte un moyen de réglage pour déplacer un module de tête à implanter (10, 11, 12) logé vers un déplacement uni-, bi- et/ou tridimensionnel du module de tête à implanter (10, 11, 12) logé, par rapport au dispositif de réception (3).

12. Automate d'alimentation pour l'implantation de substrats avec des composants, lequel comporte une tête à implanter selon l'une quelconque des revendications précédentes 1 à 11.

13. Procédé d'alimentation pour l'implantation de substrats avec des composants, pour lequel une tête à implanter est utilisée selon l'une quelconque des revendications précédentes 1 à 11.
